(19) Europäisches Patentamt / European Patent Office / Office européen des brevets

(11) **EP 2 669 982 B1**

(12) **FASCICULE DE BREVET EUROPEEN**

(45) Date de publication et mention
de la délivrance du brevet:
**04.03.2015 Bulletin 2015/10**

(51) Int Cl.:
**H01M 8/04** *(2006.01)*    **G01R 31/36** *(2006.01)*

(21) Numéro de dépôt: **13168606.5**

(22) Date de dépôt: **21.05.2013**

(54) **Procédé de la mesure de la reproductibilité de N assemblages unitaires membrane échangeuse d'ions/électrodes par introduction d'agent polluant**

Messverfahren der Reproduzierbarkeit von N miteinander verbundenen Elektroden/ Ionenaustauschmembrananordnungen durch Einführung eines verunreinigenden Stoffes

Method for measuring the reproducibility of N individual electrode- / ion-exchange membrane assemblies by introducing a pollutant

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.05.2012 FR 1254917**

(43) Date de publication de la demande:
**04.12.2013 Bulletin 2013/49**

(73) Titulaire: **COMMISSARIAT A L'ENERGIE ATOMIQUE ET AUX ENERGIES ALTERNATIVES 75015 Paris (FR)**

(72) Inventeurs:
• **Passot, Sylvain**
  **38210 Tullins (FR)**
• **Lemaire, Olivier**
  **38490 Les Abrets (FR)**
• **Faure, Christel**
  **38210 Tullins (FR)**
• **Franco, Alejandro**
  **38320 Eybens (FR)**

(74) Mandataire: **Esselin, Sophie et al
Marks & Clerk France
Conseils en Propriété Industrielle
Immeuble Visium
22, Avenue Aristide Briand
94117 Arcueil Cedex (FR)**

(56) Documents cités:
WO-A1-2006/096956      JP-A- 2005 142 062
US-A1- 2006 166 052      US-A1- 2008 197 857

• XIAO-ZI YUAN ET AL: "A review of polymer electrolyte membrane fuel cell durability test protocols", JOURNAL OF POWER SOURCES, ELSEVIER SA, CH, vol. 196, no. 22, 28 juillet 2011 (2011-07-28), pages 9107-9116, XP028283627, ISSN: 0378-7753, DOI: 10.1016/J.JPOWSOUR. 2011.07.082 [extrait le 2011-08-10]

# Description

Le domaine de l'invention est celui des piles à combustible à membrane échangeuse de protons, couramment dénommés par l'acronyme « PEMFC » correspondant au terme anglais : « Proton Exchange Membrane Fuel cell ».

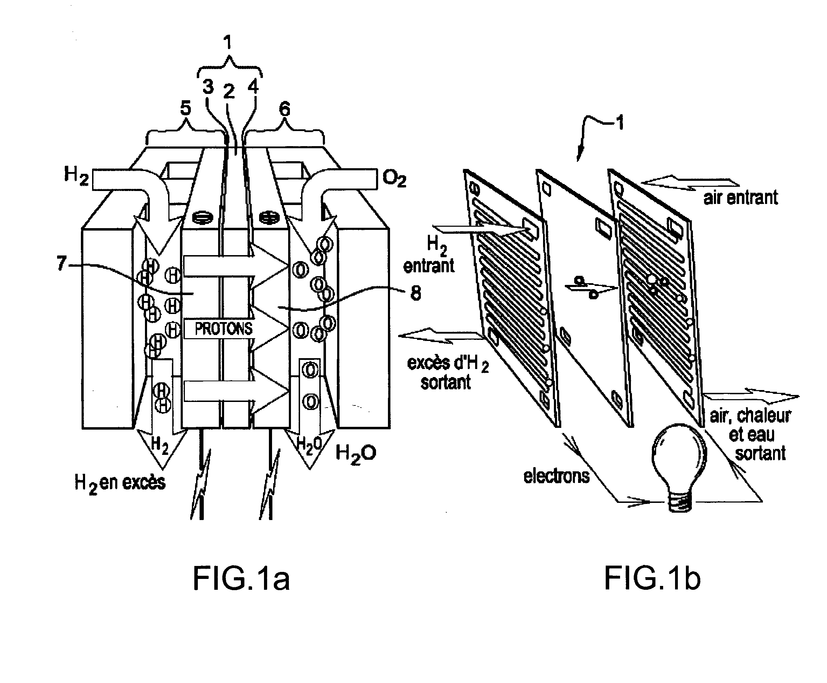

Les PEMFC sont des générateurs de courant dont le principe de fonctionnement repose sur la conversion de l'énergie chimique en énergie électrique par réaction catalytique de l'hydrogène et de l'oxygène. Les assemblages membrane-électrodes (AME) appelés communément coeurs de pile 1 constituent les éléments de base des PEMFC. Ils sont composés d'une membrane polymère 2 et de couches catalytiques 3 et 4, présentes d'un côté et de l'autre de la membrane. La membrane permet donc de séparer les compartiments anodique 5 et cathodique 6. Les couches catalytiques sont généralement constituées de nano-particules de platine supportées sur des agrégats de carbone (généralement du noir de carbone). Des couches de diffusion gazeuse 7 et 8 (tissu de carbone, feutre...) sont disposées de part et d'autre de l'AME pour assurer la conduction électrique, l'arrivée homogène des gaz réactifs et l'évacuation de l'eau produite.A l'anode, la décomposition de l'hydrogène adsorbé sur le catalyseur produit des protons $H^+$ et des électrons $e^-$. Les protons traversent ensuite la membrane polymère avant de réagir avec l'oxygène à la cathode. La réaction des protons avec l'oxygène à la cathode conduit à la formation d'eau et à la production de chaleur comme représenté en figures 1 a et 1 b.

En fonction de la méthode de production d'hydrogène, le gaz peut comporter des impuretés. Il a été montré que le monoxyde de carbone et les composés soufrés sont particulièrement néfastes pour le fonctionnement de la pile. Dans ce contexte, des seuils de concentrations maximales ont été proposés pour normaliser la qualité de l'hydrogène utilisé pour les piles à combustible dans le cas d'une application automobile : par exemple, 0,2 $\mu$mol/mol pour le CO et 0,004 $\mu$mol/mol pour les composés soufrés. Ces valeurs proposées en comité technique de normalisation peuvent évoluer.

En vue d'une production de masse d'électrodes et d'AME pour piles à combustible de type PEM, il est primordial de fiabiliser la méthode pour vérifier la reproductibilité des performances des AME, sachant que ces composants sont amenés à fonctionner dans une très large gamme de conditions.

Les conditions les plus communément utilisées sont les suivantes :

- une température comprise entre environ 60°C et 120°C :
- une pression comprise entre la pression atmosphérique et environ 2 bars ;
- un taux d'humidité relatif compris entre environ 0% et 100% ;
- un coefficient stoechiométrique compris entre 1 et 2, voire plus.

L'anode est généralement alimentée en combustible à base d'hydrogène et la cathode en comburant à base d'oxygène.

Les tests de validation des performances se font en général dans des conditions optimales de fonctionnement de la pile à combustible PEM (température, pressions, humidités, débits, gaz), c'est-à-dire en hydrogène pur pour assurer le bon fonctionnement de l'anode et en air ou en oxygène pur à la cathode. Les méthodes de caractérisation électrochimique sont nombreuses. Les poudres catalytiques et les encres peuvent être étudiées ex-situ, par exemple par la méthode dite tournante -RDE- Koutecky Levich.

Les méthodes de caractérisation in-situ les plus courantes sont la courbe de polarisation, la voltampérométrie cyclique « CV » comme décrit notamment dans la demande de brevet de O. Masaki, *Electrode performance evaluation method and evaluation device of polymer electrolyte fuel cell,* JP2004220786, 2004, et la spectroscopie car l'électrode étudiée est alimentée en gaz neutre. La courbe de polarisation et la spectroscopie d'impédance sont réalisées dans les conditions opératoires.

On peut définir des conditions opératoires optimales, ou bien travailler dans des conditions opératoires non optimales.

C'est dans cette dernière catégorie de conditions que se situe la présente invention.

Plus précisément, les solutions proposées selon l'art connu peuvent utiliser les techniques suivantes :

La mesure de la capacité électrique d'un AME :

Nissan a proposé une solution simple et rapide pour évaluer les performances d'une électrode de PEMFC (O. Masaki, *Electrode performance evaluation method and evaluation device of polymer electrolyte fuel cell,* JP2004220786, 2004*)*. La solution repose sur la mesure de la capacité électrique de l'électrode exposée à un gaz inerte lors d'un cycle de potentiel. La capacité de la double couche électrique augmente avec la surface du catalyseur platiné en contact avec l'électrolyte. Cette solution technique est cependant peu représentative des performances de l'électrode dans les conditions opératoires d'une pile PEM. Elle est rapide mais peu précise.

La caractérisation d'un AME sous faible humidité :

Toyota a proposé une méthode de test en utilisant une humidité relative faible. La résistance de diffusion des gaz étant plus haute à faible humidité, les performances seront nécessairement meilleures sous conditions d'humidités relatives plus hautes comme décrit dans la demande de brevet : I.K.N.J.O. Shinobu, *Method of testing membrane electrode assembly,* JP2010251185, 2010. Cette solution évalue principalement la gestion de l'eau et très peu l'activité catalytique des couches actives.

La détection d'un AME défectueux dans un ensemble appelé « stack » :

Une solution proposée pour tester les défauts d'un AME parmi un ensemble d'AME consiste en la comparaison de la mesure de la tension de cellule de chaque AME avec la tension de cellule moyennée sur l'ensemble des AME comme décrit dans Y.Sun, G. Xiao, *Method for testing defects of single membrane electrode assembly in the fuel cell stack,* CN101566594, 2009. Les mesures sont effectuées dans des conditions optimales. L'inconvénient est que cette méthode ne permet pas de détecter les légères différences de performances entre plusieurs AME.

Par ailleurs, Samsung a protégé une méthode et un banc d'essai pouvant tester un ensemble d'AME comme décrit dans le brevet C. G. Shin, *Multi-MEA test station and multi-MEA method using the same,* US2008/0197857 A1. 2008. Ce banc d'essai comprend toute la chaine d'assemblage des AME à température et humidité constante dans des cellules alimentées en combustible et comburant, ainsi que l'équipement pour mesurer les paramètres de performance de chaque AME. Le banc permet également l'activation des AME et le processus de purge. Cette solution technique ne permet pas l'injection d'impuretés telles que le monoxyde de carbone ou le sulfure d'hydrogène dans l'alimentation en gaz des AME. Ainsi, par rapport aux mesures classiques de test de reproductibilité, la présente invention propose un procédé original basé sur l'introduction d'espèce polluante permettant d'accentuer les différences de performances.

Plus précisément, et dans ce contexte, la présente invention propose de caractériser des AME en exploitant une dose d'entité polluante présente dans au moins un des flux d'alimentation et permettant avantageusement d'amplifier les différences entre les différentes AME d'une même série.

Plus précisément, la présente invention a pour objet un procédé de la mesure de la reproductibilité des performances de N assemblages unitaires membrane échangeuse d'ions /électrodes, avec N entier strictement supérieur à 1, chaque assemblage contenant une membrane échangeuse d'ions située entre une anode alimentée par un premier flux et une cathode alimentée par un second flux et possédant des caractéristiques de tension de cellule **caractérisé en ce qu'il** comporte les étapes suivantes :

- l'introduction dans chaque assemblage unitaire d'un flux contenant au moins une espèce polluante pendant une durée donnée ;
- une mesure d'au moins un paramètre électrochimique de chaque assemblage ;
- la comparaison desdites mesures de manière à évaluer la reproductivité desdits assemblages.

Selon une variante de l'invention, la mesure électrochimique est une mesure de la tension entre l'anode et la cathode.

Selon une variante de l'invention, la mesure électrochimique est une mesure de l'impédance de ladite cellule.

Selon une variante de l'invention, le procédé comprend :

- la détermination de l'écart type de l'ensemble desdites mesures ;
- la comparaison dudit écart type par rapport à une valeur seuil prédéfinie de tolérance.

Selon une variante de l'invention, la mesure de la tension de chaque assemblage est effectuée par l'application d'un courant continu.

Selon une variante de l'invention, la mesure d'impédance est effectuée par l'application d'oscillations de courant permettant de définir le spectre d'impédance électrochimique desdits assemblages.

Selon une variante de l'invention, l'anode comprend un catalyseur comportant du platine.

Selon une variante de l'invention, l'anode comprend un catalyseur comportant du platine et du ruthénium.

Selon une variante de l'invention, l'introduction d'au moins une espèce polluante est réalisée à l'anode avec un flux d'hydrogène contenant une espèce polluante à base de composé carbonylé pouvant être : CO ou $CH_2O$.

Selon une variante de l'invention, l'introduction d'au moins une espèce polluante est réalisée à l'anode avec un gaz contenant une espèce comportant du soufre et pouvant être : $H_2S$, $CS_2$, $SO_2$.

Selon une variante de l'invention, l'introduction d'au moins une espèce polluante est réalisée à la cathode avec un gaz contenant du $SO_x$ avec x = 1 ou x = 2.

Selon une variante de l'invention, l'introduction d'au moins une espèce polluante est réalisée à la cathode avec un gaz contenant du $NO_y$ avec y = 1 ou y = 2.

Selon une variante de l'invention, l'introduction d'au moins une espèce polluante est réalisée au niveau du flux d'alimentation de l'anode et au niveau du flux d'alimentation de la cathode.

Selon une variante de l'invention, l'introduction d'au moins une espèce polluante est réalisée à l'anode ou à la cathode en injectant des espèces pouvant diminuer la conductivité protonique de ladite membrane échangeuses d'ions.

Selon une variante de l'invention, l'espèce polluante est du $NH_3$.

L'invention a aussi pour objet un dispositif pour mesurer la reproductivité de N assemblages unitaires membrane échangeuse d'ions/électrodes comportant :

- un ensemble de N cellules élémentaires alimentées en un premier flux à l'anode et en un second flux à la cathode ;
- des moyens de mesure d'au moins un paramètre électrochimique de chaque assemblage ;
- des moyens de comparaison desdites mesures de paramètre électrochimique ;
- un premier moyen d'alimentation d'un premier flux à l'anode ;
- un second moyen d'alimentation d'un second flux à la cathode, **caractérisé en ce qu'il** comprend au moins :
- un troisième moyen d'alimentation d'au moins un agent polluant communiquant avec au moins le premier ou le second moyen d'alimentation.

Selon une variante de l'invention, le troisième moyen comprend un conteneur en agent polluant relié au premier ou au second moyen d'alimentation.

Selon une variante de l'invention, le troisième moyen comporte en outre un moyen de contrôler le débit de l'agent polluant introduit.

Selon une variante de l'invention, le premier moyen comprend un conteneur d'hydrogène.

Selon une variante de l'invention, le second moyen comprend une prise d'air.

L'invention sera mieux comprise et d'autres avantages apparaîtront à la lecture de la description qui va suivre donnée à titre non limitatif et grâce aux figures annexées parmi lesquelles :

- les figures 1a et 1b illustrent un schéma du principe de fonctionnement d'une pile à combustible PEMFC ;
- la figure 2 illustre l'évolution de la tension de cellule pour trois AME d'un premier lot dit lot n °1, en présence de 250 ppb de $H_2S$ contenu dans le premier flux de combustible ;
- les figures 3a et 3b illustrent respectivement les spectres d'impédance électrochimique pour trois AME dudit premier lot, à l'état initial et après 50 heures d'empoisonnement par 250 ppb de $H_2S$ contenu dans le premier flux de combustible pour des mesures réalisées à 0,6 A cm$^{-2}$ ;
- la figure 4 illustre l'évolution de la tension de cellule pour trois AME d'un second lot dit lot n °2, en présence de 250 ppb de $H_2S$ contenu dans le premier flux de combustible ;
- les figures 5a et 5b illustrent respectivement les spectre d'impédance électrochimique pour trois AME dudit second lot, à l'état initial et après 50 heures d'empoisonnement par 250 ppb de $H_2S$ contenu dans le premier flux de combustible pour des mesures réalisées à 0,6 A cm$^{-2}$ ;
- la figure 6 illustre un exemple de dispositif selon l'invention permettant de mettre en oeuvre la présente invention.

La présente invention a ainsi pour objet une méthode consistant à caractériser une série d'AME dans les conditions de fonctionnement, en utilisant un agent polluant présent dans au moins un des flux d'alimentation.

Le Demandeur propose ainsi par exemple d'évaluer les performances d'un ensemble d'AME en présence d'agent polluant dans le combustible.

Dans un ensemble d'AME parfaitement identiques, l'impact de l'empoisonnement par un agent polluant de $H_2S$ contenu dans le flux de combustible de $H_2$, est le même. Dans un ensemble d'AME avec de légères variations des paramètres structuraux (chargement, composition de l'encre...), l'utilisation d'un agent polluant permet, selon la présente invention, d'amplifier les différences de performances.

Par exemple à l'anode, un nombre limité de sites actifs permet de subvenir à l'établissement du courant. En hydrogène pur, la différence de performance entre deux anodes de chargements proches est donc minime.

Il peut donc être particulièrement pertinent d'utiliser un polluant pouvant être par exemple du $H_2S$. En effet, en présence d'une même quantité de polluant comme $H_2S$, le même nombre de sites actifs est empoisonné car $H_2S$ s'adsorbe très facilement et très fortement sur le platine. Le nombre de sites actifs est donc réduit et la différence entre les deux anodes est amplifiée.

Le polluant peut être un composé soufré ($H_2S$, $CS_2$, $SO_2$...) ou un composé carbonylé (CO, $CH_2O$...).

La solution proposée dans la présente invention permet ainsi d'identifier les différences entre, au moins deux AME, pouvant notamment provenir d'une légère différence de chargement en catalyseur, d'une légère différence de structure de la couche active, d'une légère différence des compositions des matériaux utilisés lors de la fabrication de l'AME.

Cette solution permet donc de détecter de très petites différences qui ne sont pas détectables avec les « méthodes de contrôle-qualité » habituellement utilisées. Dans le cadre d'une ligne-pilote de fabrication d'AME, cette solution peut être utilisée pour vérifier la reproductibilité des AME au sein d'un même lot ou entre différents lots par échantillonnage.

Il peut aussi être intéressant de tester des écarts de reproductibilité en injectant un flux à la cathode contenant également une espèce polluante.

Dans le cas d'une alimentation classique en oxygène pouvant notamment être réalisée à partir de l'air, il peut avantageusement être procéder à l'injection en quantité contrôlée d'espèces de type $SO_x$ ou $NO_y$.

L'espèce polluante peut être injectée dans un des flux d'alimentation au niveau des électrodes : anode ou cathode, mais peut également être injectée pour agir au niveau de la membrane, en injectant par exemple du $NH_3$ au niveau du combustible ($H_2$) ou dans le comburant (air).

L'utilisation de ce type de polluant permet par exemple d'évaluer les légères différences de capacité d'échange ionique des membranes échangeuses de protons.

Le polluant peut donc également être de l'ammoniac, des ions ammonium ($NH_4^+$) ou tout autres cations pouvant s'échanger dans la membrane ionomère ($Na^+$, $Ca^+$, $K^+$...).

La mesure de la différence de performance peut être réalisée à partir de la mesure de la tension et à partir de la détermination de la résistance de polarisation (impédance à basse fréquence, dans le cas du sulfure d'hydrogène) ou de la résistance ohmique (impédance à haute fréquence, dans le cas de l'ammoniac).

L'homogénéité des performances de l'ensemble des AME testé est mesurée en calculant l'écart-type relatif, c'est-à-dire le rapport de l'écart-type sur la moyenne.

Il est rappelé que l'écart type est défini par la relation ci-après :

$$E = [1/n \sum (n_i - m)^2]^{1/2}$$

avec n le nombre d'essais et m la moyenne des valeurs de tension mesurée, ni étant la valeur de chacune des tensions mesurées.

Un écart-type relatif proche de zéro signifie que les performances sont répétables/reproductibles. Un niveau de reproductibilié peut être défini à partir de ces mesures.

Exemple de méthode de test selon l'invention sur un premier Lot n°1 de 3 AME :

Le Demandeur a testé un premier Lot d'AME n°1, constitué de trois AME. Les trois AME du même lot ont été testés dans les mêmes conditions avec 250 ppb de $H_2S$.

Les performances à $t_0$ correspondent aux performances en hydrogène pur. L'écart-type relatif en hydrogène pur est de 1%. En hydrogène pur, les performances de ces trois AME sont donc pratiquement semblables.

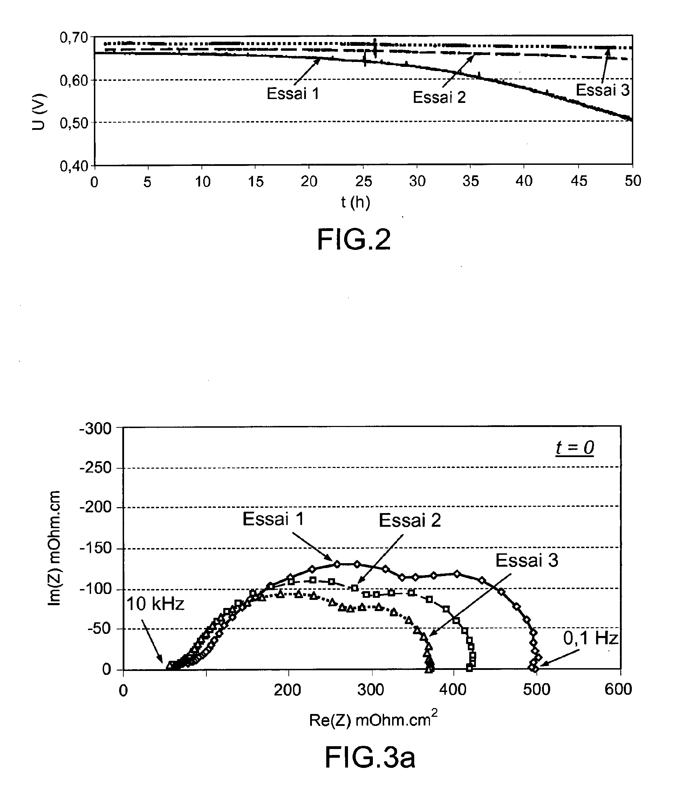

On procède alors à l'alimentation par un flux de combustible de $H_2$ contenant une espèce polluante par exemple de $H_2S$, la figure 2 illustre l'évolution des performances obtenues au cours du temps (indiqué en heures) en mesurant la tension de la cellule U en volts.

L'empoisonnement avec 250 ppb de $H_2S$ pendant 50 heures conduit à une perte de tension de 165 mV, 31 mV et 16 mV pour les Essai 1, Essai 2 et Essai 3 respectivement. L'écart-type relatif après 50 heures d'exposition est donc de 15%. Les performances de ces trois AME ne sont donc plus semblables. Les légères différences de performance visibles en hydrogène pur ont été amplifiées par l'empoisonnement par $H_2S$.

Il peut être également très intéressant de procéder à des mesures basées sur une commande, en procédant à des oscillations sur le courant imposé, pour en déterminer les oscillations obtenues sur la tension mesurée, permettant ainsi de définir une impédance complexe et une impédance réelle.

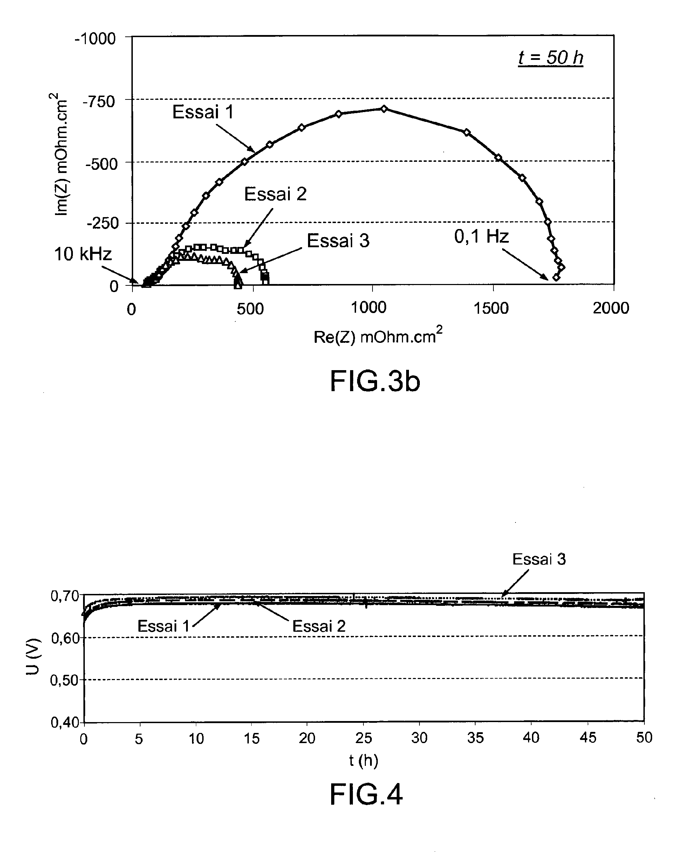

Les figures 3a et 3b montrent ainsi respectivement les spectres d'impédance électrochimique pour les trois AME du lot n°1, à l'état initial et après 50 heures d'empoisonnement par 250 ppb pour des mesures réalisées à 0,6 A $cm^{-2}$.

Les mesures à 10kHz sont représentatives de la résistance ohmique de la membrane, les mesures à 1 Hz étant représentatives de la résistance de polarisation du catalyseur au niveau de l'anode.

Une différence de performance en hydrogène pur (à $t_0$) est observée sur les spectres d'impédance électrochimique et notamment sur la résistance de polarisation. Les différences de résistance à basses fréquences (typiquement 0,1 Hz) mettent en évidence des comportements très différents à $t_0$ et au bout de 50 heures comme le montrent les courbes des figures 3a et 3b.

L'écart-type relatif sur la résistance de polarisation en hydrogène pur est de 15% (figure 3a).

Cette différence est ensuite amplifiée par l'empoisonnement : après 50 heures d'exposition à $H_2S$, l'écart-type relatif sur les résistances de polarisation est de 80% (figure 3b).

Exemple de méthode de test selon l'invention sur un second Lot n°2 de 3 AME :

Trois AME d'un autre lot ont été testés dans les mêmes conditions avec 250 ppb de $H_2S$. Les performances à $t_0$ correspondent aux performances en hydrogène pur. L'écart-type relatif en hydrogène pur est de 1%. En hydrogène pur, les performances de ces trois AME sont donc à nouveau pratiquement semblables.

La figure 4 illustre l'évolution des performances obtenues au cours du temps en mesurant la tension de la cellule U en volts.

L'empoisonnement avec 250 ppb de $H_2S$ pendant 50 heures conduit à une perte de tension inférieure à 5 mV pour les Essai 1, Essai 2 et Essai 3. L'écart-type relatif après 50 heures d'exposition est de 1%. Les performances de ces trois AME restent pratiquement semblables.

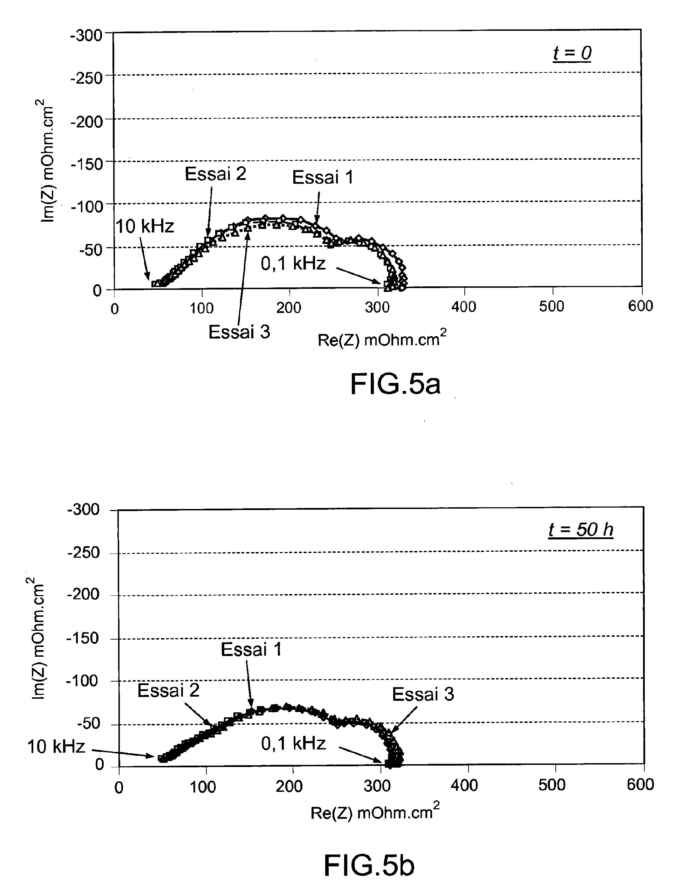

Les figures 5a et 5b montrent ainsi respectivement les spectres d'impédance électrochimique pour trois AME du lot n°2, à l'état initial et après 50 heures d'empoisonnement par 250 ppb pour des mesures réalisées à 0,6 A $cm^{-2}$.

La reproductibilité des performances en hydrogène pur (à $t_0$) est également observée sur les spectres d'impédance électrochimique (figure 5a) et notamment sur la résistance de polarisation. L'écart-type relatif sur la résistance de polarisation en hydrogène pur est de 2%. Cette différence est ensuite atténuée par l'empoisonnement : après 50 heures avec un flux conte-

nant du $H_2S$, l'écart-type relatif sur les résistances de polarisation est de 1% (figure 5b).

Il apparaît ainsi que pour le Lot n °1, l'écart-type relatif sur la tension passe de 1 % en hydrogène pur à 15% après 50 heures d'exposition à $H_2S$. L'écart-type relatif sur la résistance de polarisation passe respectivement de 15% à 80%. Pour le Lot n °2, l'écart-type relatif sur la tension reste à 1% malgré les 50 heures d'exposition à $H_2S$. L'écart-type relatif sur la résistance de polarisation est atténué de 2% à 1 %.

Il apparait donc bien que la solution d'empoisonnement proposée selon la présente invention, par un agent polluant $H_2S$ introduit dans le flux de combustible de ces AME permet ainsi bien d'amplifier les différences de performances et donc de vérifier avec précision la reproductibilité de différentes AME.

Exemple de dispositif permettant de mettre en oeuvre la méthode de test selon l'invention :

Il peut s'agir pour l'essentiel d'un banc de test comprenant un certains nombre de moyens communs à ceux décrits dans le brevet de Samsung concernant une méthode et un banc d'essai pouvant tester un ensemble d'AME, US2008/0197857.

Ainsi un exemple de banc d'essai selon l'invention peut comprendre toute la chaine d'assemblage des AME à température et humidité constante dans des cellules alimentées en premier moyen fournissant du combustible et en second moyen fournissant du comburant couplé à un système de régulation Reg, ainsi que l'équipement pour mesurer les paramètres de performance de chaque AME. Le banc permet également l'activation des AME et le processus de purge via des moyens de purge Purge. Selon l'invention, il est de plus prévu un troisième moyen d'alimentation en espèce polluante.

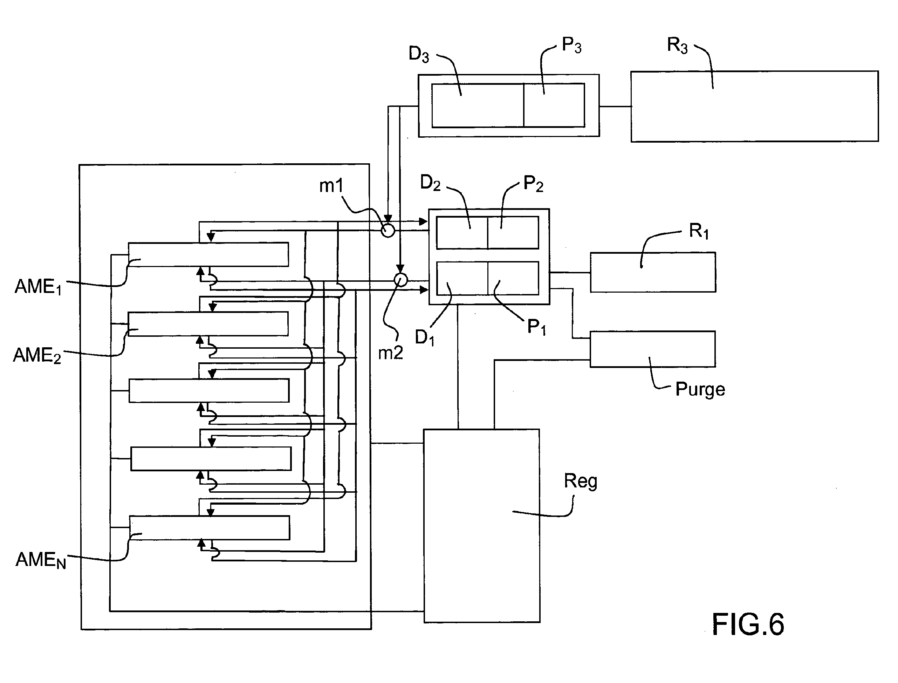

Comme illustré en figure 6, un ensemble d'AME : $AME_1$, $AME_2$, ..., AMEN sont alimentés par un premier flux contenant du $H_2$ et un second flux contenant du $O_2$.

Le flux de $H_2$ provient d'un réservoir R1 de $H_2$, couplé à une pompe P1 et un débitmètre D1.

L'oxygène de l'air est pompé via une pompe P2 couplée à un débitmètre D2.

L'agent polluant est prélevé depuis un conteneur d'agent polluant R3 est prévu pouvant par exemple être une bouteille de gaz, une pompe P3 est également prévue pour réaliser l'alimentation en agent polluant ainsi qu'un débitmètre D3 pour la distribution dudit agent polluant. Le mélange de l'agent polluant peut être fait au niveau des connections m1 ou m2 avec les alimentations principales en combustible ou en comburant.Un système de régulation Reg tel que décrit précédemment est également prévu.

## Revendications

1. Procédé de la mesure de la reproductibilité des performances de N assemblages unitaires membrane échangeuse d'ions /électrodes, avec N entier strictement supérieur à 1, chaque assemblage contenant une membrane échangeuse d'ions située entre une anode alimentée par un premier flux et une cathode alimentée par un second flux et possédant des caractéristiques de tension de cellule **caractérisé en ce qu'il** comporte les étapes suivantes :

   - l'introduction dans chaque assemblage unitaire d'un flux contenant au moins une espèce polluante pendant une durée donnée ;
   - une mesure d'au moins un paramètre électrochimique de chaque assemblage ;
   - la comparaison desdites mesures de manière à évaluer la reproductivité desdits assemblages.

2. Procédé de la mesure de la reproductibilité des performances de N assemblages unitaires membrane échangeuse d'ions /électrodes selon la revendication 1, **caractérisé en ce que** la mesure électrochimique est une mesure de la tension entre l'anode et la cathode.

3. Procédé de la mesure de la reproductibilité de N assemblages unitaires membrane échangeuse d'ions /électrodes selon la revendication 1, **caractérisé en ce que** la mesure électrochimique est une mesure de l'impédance de ladite cellule.

4. Procédé de la mesure de la reproductibilité des performances de N assemblages unitaires membrane échangeuse d'ions/électrodes selon l'une des revendications 1 à 3, **caractérisé en ce qu'il** comprend :

   - la détermination de l'écart type de l'ensemble desdites mesures ;
   - la comparaison dudit écart type par rapport à une valeur seuil prédéfinie de tolérance.

5. Procédé de la mesure de la reproductibilité des performances de N assemblages unitaires membrane échangeuse d'ions/électrodes selon revendication 2, **caractérisé en ce que** la mesure de la tension de chaque assemblage est effectuée par l'application d'un courant continu.

6. Procédé de la mesure de la reproductibilité des performances de N assemblages unitaires membrane échangeuse d'ions/électrodes selon la revendication 3, **caractérisé en ce que** la mesure d'impédance est effectuée par l'application d'oscillations de courant permettant de définir le spectre d'impédance électrochimique desdits assemblages.

7. Procédé de la mesure de la reproductibilité des performances de N assemblages membrane échangeuse d'ions /électrodes selon l'une des revendications 1 à 6, **caractérisé en ce que** l'anode comprend un catalyseur comportant du platine.

8. Procédé de la mesure de la reproductibilité des performances de N assemblages membrane échangeuse d'ions /électrodes selon l'une des revendications 1 à 6, **caractérisé en ce que** l'anode comprend un catalyseur comportant du platine et du ruthénium.

9. Procédé de la mesure de la reproductibilité des performances de N assemblages membrane échangeuse d'ions /électrodes selon l'une des revendications 7 ou 8, **caractérisé en ce que** l'introduction d'au moins une espèce polluante est réalisée à l'anode avec un flux d'hydrogène contenant une espèce polluante à base de composé carbonylé pouvant être : CO ou $CH_2O$.

10. Procédé de la mesure de la reproductibilité des performances de N assemblages membrane échangeuse d'ions /électrodes selon la revendication 8, **caractérisé en ce que** l'introduction d'au moins une espèce polluante est réalisée à l'anode avec un gaz contenant une espèce comportant du soufre et pouvant être : $H_2S$, $CS_2$, $SO_2$.

11. Procédé de mesure de la reproductivité des performances de N assemblages unitaires membrane échangeuse d'ions/électrodes selon l'une des revendications 1 à 10, **caractérisé en ce que** l'introduction d'au moins une espèce polluante est réalisée à la cathode avec un gaz contenant du $SO_x$ avec x = 1 ou x = 2.

12. Procédé de mesure de la reproductivité des performances de N assemblages unitaires membrane échangeuse d'ions /électrodes selon l'une des revendications 1 à 10, **caractérisé en ce que** l'introduction d'au moins une espèce polluante est réalisée à la cathode avec un gaz contenant du $NO_y$ avec y =1 ou y = 2.

13. Procédé de mesure de la reproductivité de N assemblages unitaires membrane échangeuse d'ions/électrodes selon l'une des revendications 1 à 12, caractérisé en ce l'introduction d'au moins une espèce polluante est réalisée au niveau du flux d'alimentation de l'anode et au niveau du flux d'alimentation de la cathode.

14. Procédé de mesure de la reproductivité des performances de N assemblages unitaires membrane échangeuse d'ions/électrodes selon l'une des revendications 1 à 5, **caractérisé en ce que** l'introduction d'au moins une espèce polluante est réalisée à l'anode ou à la cathode en injectant des espèces pouvant diminuer la conductivité protonique de ladite membrane échangeuses d'ions.

15. Procédé de mesure de la reproductivité des performances de N assemblages unitaires membrane échangeuse d'ions /électrodes selon la revendication 14, **caractérisé en ce que** l'espèce polluante est du $NH_3$.

16. Dispositif pour mesurer la reproductivité des performances de N assemblages unitaires membrane échangeuse d'ions/électrodes comportant :

    - un ensemble de N cellules élémentaires alimentées en un premier flux à l'anode et en un second flux à la cathode ;
    - des moyens de mesure d'au moins un paramètre électrochimique de chaque assemblage ;
    - des moyens de comparaison desdites mesures de paramètre électrochimique ;
    - un premier moyen d'alimentation d'un premier flux à l'anode ;
    - un second moyen d'alimentation d'un second flux à la cathode, **caractérisé en ce qu'il** comprend au moins :
    - un troisième moyen d'alimentation d'au moins un agent polluant communiquant avec au moins le premier ou le second moyen d'alimentation.

17. Dispositif pour mesurer la reproductivité des performances de N assemblages unitaires membrane échangeuse d'ions /électrodes selon la revendication 16, **caractérisé en ce que** le troisième moyen comprend un conteneur en agent polluant relié au premier ou au second moyen d'alimentation.

18. Dispositif pour mesurer la reproductivité des performances de N assemblages unitaires membrane échangeuse d'ions /électrodes selon l'une des revendications 16 ou 17, **caractérisé en ce que** le troisième moyen comporte en outre un moyen de contrôler le débit de l'agent polluant introduit.

19. Dispositif pour mesurer la reproductivité des performances de N assemblages unitaires membrane échangeuse d'ions /électrodes selon l'une des revendications 16 à 18, **caractérisé en ce que** le premier moyen comprend un conteneur d'hydrogène.

20. Dispositif pour mesurer la reproductivité des performances de N assemblages unitaires membrane échangeuse d'ions/électrodes selon l'une des revendications 16 à 19, **caractérisé en ce que** le second moyen comprend une prise d'air.

**Patentansprüche**

1. Verfahren zum Messen der Reproduzierbarkeit der Leistungen von N miteinander verbundenen Ionen-/Elektrodenaustauschmembrananordnungen, wobei N eine ganze Zahl strikt größer als 1 ist, wobei jede Anordnung eine Ionenaustauschmembran aufweist, die sich zwischen einer mit einem ersten Fluss gespeisten Anode und einer mit einem zweiten Fluss gespeisten Kathode befindet und Zellenspannungscharakteristiken aufweist, **dadurch gekennzeichnet, dass** es die folgenden Schritte beinhaltet:

   - Einleiten eines Flusses in jede verbundene Anordnung, der wenigstens eine Verunreinigungsspezies enthält, für eine gegebene Dauer;
   - Messen von wenigstens einem elektrochemischen Parameter jeder Anordnung;
   - Vergleichen der Messwerte, um die Reproduzierbarkeit der Anordnungen zu beurteilen.

2. Verfahren zum Messen der Reproduzierbarkeit von Leistungen von N miteinander verbundenen Ionen-/Elektrodenaustauschmembrananordnungen nach Anspruch 1, **dadurch gekennzeichnet, dass** die elektrochemische Messung eine Messung der Spannung zwischen der Anode und der Kathode ist.

3. Verfahren zum Messen der Reproduzierbarkeit von N miteinander verbundenen Ionen-/Elektrodenaustauschmembrananordnungen nach Anspruch 1, **dadurch gekennzeichnet, dass** die elektrochemische Messung eine Messung der Impedanz der Zelle ist.

4. Verfahren zum Messen der Reproduzierbarkeit von Leistungen von N miteinander verbundenen Ionen-/Elektrodenaustauschmembrananordnungen nach einem der Ansprüche 1 bis 3, **dadurch gekennzeichnet, dass** es Folgendes beinhaltet:

   - Ermitteln der Standardabweichung aller Messungen;
   - Vergleichen der Standardabweichung mit Bezug auf einen vordefinierten Toleranz Schwellenwert.

5. Verfahren zum Messen der Reproduzierbarkeit der Leistungen von N miteinander verbundenen Ionen-/Elektrodenaustauschmembrananordnungen nach Anspruch 2, **dadurch gekennzeichnet, dass** die Messung der Spannung jeder Anordnung durch Zuführen eines Gleichstroms bewirkt wird.

6. Verfahren zum Messen der Reproduzierbarkeit von Leistungen von N miteinander verbundenen Ionen-/Elektrodenaustauschmembrananordnungen nach Anspruch 3, **dadurch gekennzeichnet, dass** die Impedanzmessung durch Anwenden von Stromoszillationen erfolgt, die es zulassen, das elektrochemische Impedanzspektrum der Anordnungen zu definieren.

7. Verfahren zum Messen der Reproduzierbarkeit der Leistungen von N miteinander verbundenen Ionen-/Elektrodenaustauschmembrananordnungen nach einem der Ansprüche 1 bis 6, **dadurch gekennzeichnet, dass** die Anode einen Katalysator umfasst, der Platin beinhaltet.

8. Verfahren zum Messen der Reproduzierbarkeit von Leistungen von N miteinander verbundenen Ionen-/Elektrodenaustauschmembrananordnungen nach einem der Ansprüche 1 bis 6, **dadurch gekennzeichnet, dass** die Anode einen Katalysator umfasst, der Platin und Ruthenium beinhaltet.

9. Verfahren zum Messen der Reproduzierbarkeit von Leistungen von N miteinander verbundenen Ionen-/Elektrodenaustauschmembrananordnungen nach Anspruch 7 oder 8, **dadurch gekennzeichnet, dass** das Einleiten von wenigstens einer Verunreinigungsspezies an der Anode mit einem Wasserstofffluss erfolgt, der eine Verunreinigungsspezies auf der Basis einer Carbonylverbindung enthält, die CO oder $CH_2O$ sein kann.

10. Verfahren zum Messen der Reproduzierbarkeit der Leistungen von N miteinander verbundenen Ionen-/Elektrodenaustauschmembrananordnungen nach Anspruch 8, **dadurch gekennzeichnet, dass** das Einleiten von wenigstens einer Verunreinigungsspezies an der Anode mit einem Gas erfolgt, das eine Spezies enthält, die Schwefel beinhaltet und $H_2S$, $CS_2$, $SO_2$ sein kann.

11. Verfahren zum Messen der Reproduzierbarkeit der Leistungen von N miteinander verbundenen Ionen-/Elektrodenaustauschmembrananordnungen nach einem der Ansprüche 1 bis 10, **dadurch gekennzeichnet, dass** das Einleiten von wenigstens einer Verunreinigungsspezies an der Kathode mit einem Gas erfolgt, das $SO_x$ enthält, wobei x = 1 oder x = 2 ist.

12. Verfahren zum Messen der Reproduzierbarkeit der Leistungen von N miteinander verbundenen Ionen-/Elektrodenaustauschmembrananordnungen nach einem der Ansprüche 1 bis 10, **dadurch gekennzeichnet, dass** das Einleiten von wenigstens einer Verunreinigungsspezies an der Kathode mit einem Gas erfolgt, das $NO_y$ enthält, wobei y = 1 oder y = 2 ist.

13. Verfahren zum Messen der Reproduzierbarkeit von N miteinander verbundenen Ionen-/Elektrodenaustauschmembrananordnungen nach einem der Ansprüche 1 bis 12, **dadurch gekennzeichnet, dass** das Einleiten von wenigstens einer Verunreinigungsspezies an dem Zuführungsfluss der Anode und am Zuführungsfluss der Kathode erfolgt.

14. Verfahren zum Messen der Reproduzierbarkeit der Leistungen von N miteinander verbundenen Ionen-/Elektrodenaustauschmembrananordnungen nach einem der Ansprüche 1 bis 5, **dadurch gekennzeichnet, dass** das Einleiten von wenigstens einer Verunreinigungsspezies an der Anode oder an der Kathode durch Injizieren von Spezies erfolgt, die die Protonenleitfähigkeit der Ionenaustauschmembran vermindern können.

15. Verfahren zum Messen der Reproduzierbarkeit der Leistungen von N miteinander verbundenen Ionen-/Elektrodenaustauschmembrananordnungen nach Anspruch 14, **dadurch gekennzeichnet, dass** die Verunreinigungsspezies $NH_3$ ist.

16. Vorrichtung zum Messen der Reproduzierbarkeit der Leistungen von N miteinander verbundenen Ionen-/Elektrodenaustauschmembrananordnungen, die Folgendes umfasst:

> - einen Satz von N elementaren Zellen, die mit einem ersten Fluss an der Anode und einem zweiten Fluss an der Kathode gespeist werden;
> - Mittel zum Messen von wenigstens einem elektrochemischen Parameter jeder Anordnung;
> - Mittel zum Vergleichen der elektrochemischen Parametermesswerte;
> - ein erstes Mittel zum Zuführen eines ersten Flusses zu der Anode;
> - ein zweites Mittel zum Zuführen eines zweiten Flusses zu der Kathode, **dadurch gekennzeichnet, dass** sie wenigstens Folgendes umfasst:
> - ein drittes Mittel zum Zuführen von wenigstens einem Verunreinigungsagens, das mit wenigstens dem ersten oder dem zweiten Zuführungsmittel kommuniziert.

17. Vorrichtung zum Messen der Reproduzierbarkeit der Leistungen von N miteinander verbundenen Ionen-/Elektrodenaustauschmembrananordnungen nach Anspruch 16, **dadurch gekennzeichnet, dass** das dritte Mittel einen Behälter mit Verunreinigungsagens umfasst, der mit dem ersten oder dem zweiten Zuführungsmittel verbunden ist.

18. Vorrichtung zum Messen der Reproduzierbarkeit der Leistungen von N miteinander verbundenen Ionen-/Elektrodenaustauschmembrananordnungen nach Anspruch 16 oder 17, **dadurch gekennzeichnet, dass** das dritte Mittel ferner ein Mittel zum Regeln der Ausgabe des eingeleiteten Verunreinigungsagens umfasst.

19. Vorrichtung zum Messen der Reproduzierbarkeit der Leistungen von N miteinander verbundenen Ionen-/Elektrodenaustauschmembrananordnungen nach einem der Ansprüche 16 bis 18, **dadurch gekennzeichnet, dass** das erste Mittel einen Wasserstoffbehälter umfasst.

20. Vorrichtung zum Messen der Reproduzierbarkeit der Leistungen von N miteinander verbundenen Ionen-/Elektrodenaustauschmembrananordnungen nach einem der Ansprüche 16 bis 19, **dadurch gekennzeichnet, dass** das zweite Mittel einen Lufteinlass umfasst.

**Claims**

1. Method for measuring the reproducibility of the performance levels of N unitary ion/electrode exchange membrane assemblies, with the integer N being strictly greater than 1, each assembly containing an ion exchange membrane which is located between an anode which is supplied by a first flux and a cathode which is supplied by a second flux and which has characteristics of cell voltage, **characterised in that** it comprises the following steps:

> - introducing into each unitary assembly a flux which contains at least one polluting species for a given period of time;
> - measuring at least one electrochemical parameter of each assembly;
> - comparing the measurements in order to evaluate the reproductivity of the assemblies.

2. Method for measuring the reproducibility of the performance levels of N unitary ion/electrode exchange membrane assemblies according to claim 1, **characterised in that** the electrochemical measurement is a measurement of the voltage between the anode and the cathode.

3. Method for measuring the reproducibility of the performance levels of N unitary ion/electrode exchange membrane assemblies according to claim 1, **characterised in that** the electrochemical measurement is a measurement of the impedance of the cell.

4. Method for measuring the reproducibility of the performance levels of N unitary ion/electrode exchange membrane assemblies according to any one of claims 1 to 3, **characterised in that** it comprises:

> - determining the standard deviation of all of the measurements;
> - comparing the standard deviation with a predefined threshold tolerance value.

5. Method for measuring the reproducibility of the performance levels of N unitary ion/electrode exchange membrane assemblies according to claim 2, **characterised in that** the measurement of the voltage of each assembly is carried out by means of the application of a continuous current.

6. Method for measuring the reproducibility of the performance levels of N unitary ion/electrode exchange membrane assemblies according to claim 3, **characterised in that** the measurement of impedance is carried out by means of the application of oscillations of current which allow the range of electrochemical impedance of the assemblies to be defined.

7. Method for measuring the reproducibility of the performance levels of N unitary ion/electrode exchange membrane assemblies according to any one of claims 1 to 6, **characterised in that** the anode comprises a catalyst which comprises platinum.

8. Method for measuring the reproducibility of the performance levels of N unitary ion/electrode exchange membrane assemblies according to any one of claims 1 to 6, **characterised in that** the anode comprises a catalyst which comprises platinum and ruthenium.

9. Method for measuring the reproducibility of the performance levels of N unitary ion/electrode exchange membrane assemblies according to either claim 7 or claim 8, **characterised in that** the introduction of at least one polluting species is carried out at the anode with a flux of hydrogen which contains a polluting species based on carbonyl-containing compound which may be: CO or $CH_2O$.

10. Method for measuring the reproducibility of the performance levels of N unitary ion/electrode exchange membrane assemblies according to claim 8, **characterised in that** the introduction of at least one polluting species is carried out at the anode with a gas containing a species which comprises sulphur and which may be: $H_2S$, $CS_2$, $SO_2$.

11. Method for measuring the reproductivity of the performance levels of N unitary ion/electrode exchange membrane assemblies according to any one of claims 1 to 10, **characterised in that** the introduction of at least one polluting species is carried out at the cathode with a gas containing $SO_x$ with x = 1 or x = 2.

12. Method for measuring the reproductivity of the performance levels of N unitary ion/electrode exchange membrane assemblies according to any one of claims 1 to 10, **characterised in that** the introduction of at least one polluting species is carried out at the cathode with a gas containing $NO_y$ with y = 1 or y = 2.

13. Method for measuring the reproductivity of N unitary ion/electrode exchange membrane assemblies according to any one of claims 1 to 12, **characterised in that** the introduction of at least one polluting species is carried out in the region of the supply flux of the anode and in the region of the supply flux of the cathode.

14. Method for measuring the reproductivity of the performance levels of N unitary ion/electrode exchange membrane assemblies according to any one of claims 1 to 5, **characterised in that** the introduction of at least one polluting species is carried out at the anode or at the cathode by injecting species which may decrease the proton conductivity of the ion exchange membrane.

15. Method for measuring the reproductivity of the performance levels of N unitary ion/electrode exchange membrane assemblies according to claim 14, **characterised in that** the polluting species is $NH_3$.

16. Device for measuring the reproductivity of the performance levels of N unitary ion/electrode exchange membrane assemblies comprising:

- an assembly of N elementary cells which are supplied with a first flux at the anode and a second flux at the cathode;
- means for measuring at least one electrochemical parameter of each assembly;
- means for comparing the electrochemical parameter measurements;
- a first means for supplying a first flux to the anode;
- a second means for supplying a second flux to the cathode,
**characterised in that** it comprises at least:
- a third means which is for supplying at least one polluting agent and which communicates with at least the first or the second supply means.

17. Device for measuring the reproductivity of the performance levels of N unitary ion/electrode exchange membrane assemblies according to claim 16, **characterised in that** the third means comprises a polluting agent container which is connected to the first or second supply means.

18. Device for measuring the reproductivity of the performance levels of N unitary ion/electrode exchange membrane assemblies according to either claim 16 or claim 17, **characterised in that** the third means further comprises a means for controlling the flow rate of the polluting agent which is introduced.

**19.** Device for measuring the reproductivity of the performance levels of N unitary ion/electrode exchange membrane assemblies according to any one of claims 16 to 18, **characterised in that** the first means comprises a hydrogen container.

**20.** Device for measuring the reproductivity of the performance levels of N unitary ion/electrode exchange membrane assemblies according to any one of claims 16 to 19, **characterised in that** the second means comprises an air intake.

FIG.1a

FIG.1b

EP 2 669 982 B1

FIG.2

FIG.3a

FIG.3b

FIG.4

FIG.5a

FIG.5b

FIG.6

EP 2 669 982 B1

16

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2004220786 A
- JP 2010251185 B
- CN 101566594
- US 20080197857 A1
- US 20080197857 A